# FASCICULE DE BREVET EUROPEEN

(11) **EP 0 836 280 B1**
(45) Date de publication et mention de la délivrance du brevet: **14.05.2003**
(21) Numéro de dépôt: 97402272.5
(22) Date de dépôt: 30.09.1997
(51) Int. Cl.: H03K 17/725

(54) **Interrupteur électronique à alimentation deux fils**
Elektronischer Schalter mit Zweidraht-Versorgung
Electronic switch with two-wire supply

(30) Priorité: 11.10.1996 FR 9612469
(43) Date de publication de la demande: 15.04.1998
(73) Titulaire: LEGRAND, F-87000 Limoges (FR); LEGRAND SNC, F-87000 Limoges (FR)
(72) Inventeur: Lejeune, Pascal, 87000 Limoges (FR); Selas, Dominique, 64000 Pau (FR)
(74) Mandataire: Santarelli

(56) Documents cités:
- EP-A- 0 031 626
- HODGSON H: "A TRIAC ASSISTED NOISELESS POWER SWITCH CONCEPT" ELECTRONIC ENGINEERING, vol. 61, no. 753, 1 septembre 1989, page 25/26 XP000066064

## Description

L'invention a trait à un interrupteur à monter en série avec une charge entre deux pôles d'un réseau de distribution électrique alternative, présentant deux bornes à relier respectivement à un pôle du réseau et à la charge, celle-ci étant reliée par ailleurs à l'autre pôle du réseau, et comportant un commutateur principal à conduction bidirectionnelle déclenchée branché entre les deux bornes, et un pilote apte, en réponse à un état actif d'un signal de commande, à déclencher la conduction du commutateur principal avec un retard déterminé sur le passage à zéro de la tension entre les deux bornes, le pilote comportant une alimentation à redresseur branchée par une première entrée directement à une première des deux bornes et, par une seconde entrée à la seconde borne à travers un condensateur propre à limiter le courant dans l'alimentation.

Les interrupteurs de ce type sont couramment appelés interrupteurs à alimentation deux fils, en raison de ce que leur montage ne nécessite que deux fils.

Etant donné que, dans un tel montage, lorsque le commutateur principal est conducteur, la tension instantanée entre les deux bornes de l'interrupteur, et, en conséquence, à l'entrée de l'alimentation, est pratiquement nulle, le pilote ne serait plus alimenté si la conduction du commutateur était déclenchée au passage à zéro de la tension entre les deux bornes. Aussi prévoit-on de ne déclencher la conduction qu'avec un retard déterminé sur ce passage à zéro, pour que, entre les bornes de l'interrupteur, il apparaisse une tension approximativement triangulaire, dont la crête correspond à l'élongation de la tension entre les bornes de l'interrupteur à l'instant qui précède le déclenchement du commutateur principal. On observera que, l'impédance de la charge étant très généralement négligeable devant celle de l'alimentation du pilote, tant que la conduction du commutateur principal n'est pas déclenchée, la tension entre les bornes de l'interrupteur est la tension du réseau, de sorte que le retard de déclenchement et la tension crête entre les bornes de l'interrupteur sont strictement liés.

Il va de soi que l'alimentation du pilote doit fournir à celui-ci une tension continue relativement stable, malgré les variations de la tension entre les entrées de cette alimentation selon que l'interrupteur est fermé ou ouvert; cela implique, outre des éléments stabilisateurs de tension en aval du redresseur (siège de pertes dissipatives d'autant plus importantes que les variations effacées sont grandes), que l'on monte une impédance en série avec l'entrée de l'alimentation, impédance avantageusement réactive pour ne pas dissiper d'énergie. Pratiquement cette impédance est obtenue avec un condensateur, dit ci-dessus apte à limiter le courant dans l'alimentation.

En fait, la limitation de courant est utile surtout en régime d'ouverture de l'interrupteur, où la tension entre les entrées de l'alimentation est pratiquement la tension entre les pôles du réseau, alors que, en régime de fermeture de l'interrupteur, la tension appliquée entre les entrées de l'alimentation se réduit à celle du réseau entre chaque passage à zéro de cette dernière et le déclenchement consécutif de la conduction du commutateur principal, soit durant le retard. Or il faut que le condensateur laisse passer, pendant cette brève période, une énergie suffisante vers l'alimentation (d'autant que le pilote consommera souvent plus d'énergie en régime de fermeture de l'interrupteur). Cela conduit à utiliser un condensateur relativement encombrant et coûteux, sauf à augmenter le retard au déclenchement à l'excès.

L'invention a pour objectif de réduire l'encombrement de l'interrupteur, en réduisant celui du condensateur limiteur de courant et les dissipations d'énergie dans les composants de l'interrupteur.

Cet objectif est atteint avec un interrupteur à monter en série avec une charge entre deux pôles d'un réseau de distribution électrique alternative, présentant deux bornes à relier respectivement à un pôle du réseau et à la charge, celle-ci étant reliée par ailleurs à l'autre pôle du réseau, et comportant un commutateur principal à conduction bidirectionnelle déclenchée branché entre les deux bornes, et un pilote apte, en réponse à un état actif d'un signal de commande, à déclencher la conduction du commutateur principal avec un retard déterminé sur le passage à zéro de la tension entre les deux bornes, le pilote comportant une alimentation à redresseur branchée par une première entrée directement à une première des deux bornes et, par une seconde entrée à la seconde borne à travers un condensateur propre à limiter le courant dans l'alimentation, caractérisé en ce que le pilote comprend un commutateur auxiliaire à conduction bidirectionnelle déclenchée monté en parallèle sur le condensateur, la conduction du commutateur auxiliaire étant déclenchée à chaque passage à zéro de la tension entre les deux bornes, avec le signal de commande à l'état actif.

Grâce à cette disposition, lorsque l'interrupteur est en régime de fermeture, le condensateur est court-circuité par le commutateur auxiliaire et ne limite pas l'énergie absorbée par l'alimentation; celle-ci est alors proportionnée à l'énergie fournie au pilote, sous une tension continue correspondant sensiblement à l'élongation de tension à l'entrée de l'alimentation à l'instant du déclenchement de la conduction du commutateur principal. On peut donc choisir la valeur du condensateur pour assurer, sans plus, le maintien de la tension redressée par l'alimentation, lors du régime d'ouverture de l'interrupteur, où la tension entre les bornes de celui-ci est sensiblement la tension (pleine onde) entre les pôles du réseau.

Ainsi, aussi bien lors du régime de fermeture de l'interrupteur que de celui d'ouverture, l'alimentation reçoit une énergie dosée pour assurer le maintien à une valeur appropriée de la tension redressée qu'elle délivre.

On observera que la disposition définie ci-dessus permet, conjointement, de réduire la valeur du condensateur de limitation de courant, et en corollaire son encombrement, et de minimiser les dissipations d'énergie causées par la stabilisation de la tension redressée avec, pour corollaire, la réduction d'encombrement et prix des éléments dissipants.

De préférence, les commutateurs, principal et auxiliaire, sont des triacs avec une gâchette déclenchant la conduction dans les deux sens, pour minimiser le nombre de composants de l'interrupteur.

De préférence également, la conduction du commutateur principal est déclenchée par le passage à un niveau réglé d'une tension dérivée de la tension entre les entrées de l'alimentation. Bien que, comme on l'a fait remarquer précédemment, retard de déclenchement et crête de tension à l'instant du déclenchement soient strictement liés, le déclenchement de la conduction au passage de la tension à un niveau réglé est techniquement plus simple, et réduit les fluctuations de la tension à l'entrée de l'alimentation.

Des caractéristiques secondaires et les avantages de l'invention ressortiront d'ailleurs de la description qui va suivre, à titre d'exemple, en référence aux dessins annexés, dans lesquels:
La figure 1 est un schéma d'un interrupteur à alimentation deux fils de l'état de la technique;
La figure 2 est un diagramme des tensions entre pôles du réseau, entre les bornes d'un interrupteur à alimentation deux fils, et sur la charge;
La figure 3 est un schéma d'un interrupteur selon l'invention.

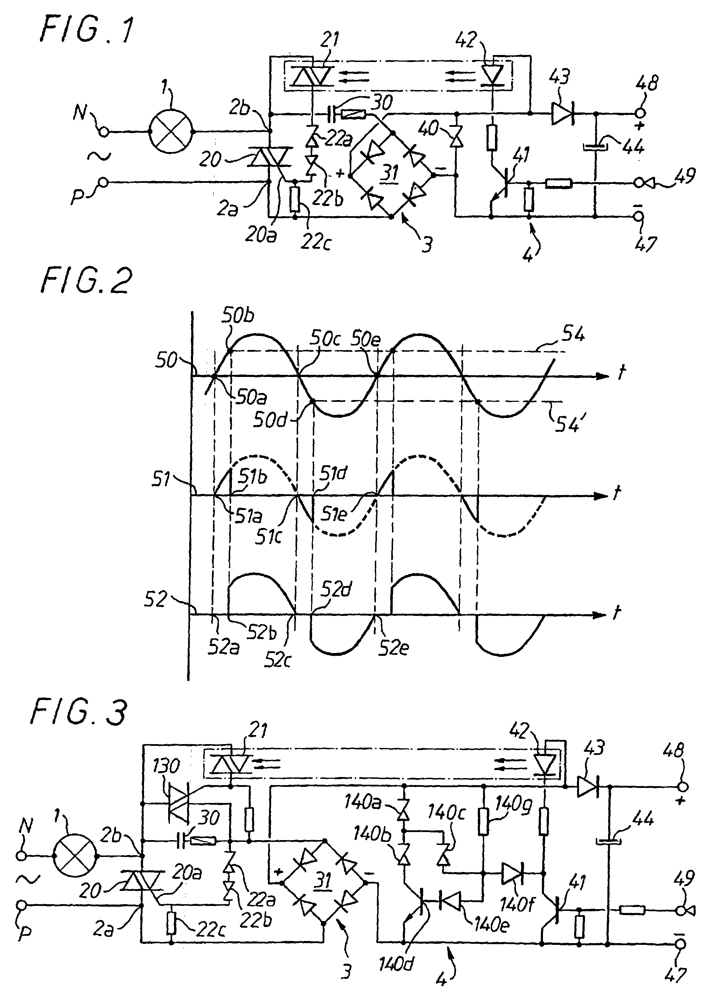

L'interrupteur à alimentation deux fils de l'état de la technique, représenté figure 1, est monté en série avec une charge 1 entre deux pôles, P (phase) et N (neutre), d'un réseau de distribution électrique alternative. Il comporte deux bornes 2a et 2b, la borne 2a étant reliée au pôle P et la borne 2b à la charge 1, celle-ci étant reliée par ailleurs au pôle N. Entre les bornes 2a et 2b est branché un triac 20, constituant commutateur principal, dont la gâchette 20a est reliée à la borne 2b à travers deux diodes Zener 22a et 22b, en série et de sens opposé, et un optotriac 21. L'interrupteur comprend en outre un redresseur 3 dans son ensemble, constitué par un pont 31 avec une première entrée reliée directement à la borne 2b et une seconde entrée reliée à la borne 2b à travers un condensateur 30, prévu pour limiter le courant qui traverse le pont redresseur 31. Celui-ci débite dans une alimentation 4, comportant une diode Zener 40 qui assure un écrêtage de la tension redressée, et une capacité de filtrage 44 en aval d'une diode anti-retour 43, de sorte que cette capacité 44 se trouve chargée sensiblement à la tension de claquage de la diode Zener 40 (24 volts). L'alimentation 4 comporte deux bornes de sortie, une borne négative 47 et une borne positive 48, par lesquelles sont alimentés des circuits annexes de l'interrupteur, constituant avec l'alimentation 4 un pilote; ce pilote sera notamment adapté à élaborer un signal de commande à partir de données représentatives des conditions suivant lesquelles, en combinaison, on a choisi de fermer et d'ouvrir l'interrupteur. L'alimentation comprend en outre un dispositif de commande de fermeture de l'interrupteur, qui comprend une diode électroluminescente 42 reliée par son anode à la sortie positive du pont 31, et par sa cathode, à travers une résistance, au collecteur d'un transistor 41, dont l'émetteur est connecté à la sortie négative du pont 31. La diode électroluminescente 42 est optiquement couplée à l'optotriac 21, afin que le déclenchement de la conduction de cet optotriac 21 soit provoqué par la luminescence de la diode 42. La base du transistor 41 reçoit, d'une borne de commande 49, un signal de commande de fermeture avec un état actif constitué par une tension, sur la borne 49, positive par rapport à la borne négative 47.

On comprend que l'état actif du signal de commande sur la borne 49 rend passant le transistor 41, et provoque la luminescence de la diode 42. Alors l'optotriac 21 voit sa conduction se déclencher sous l'effet d'une tension entre ses bornes. Or l'optotriac 21 est soumis à la tension entre les bornes 2a et 2b, à travers les diodes Zener 22a et 22b, et la résistance 22c. Ainsi la conduction de l'optotriac 21, illuminé par la diode électroluminescente, va se déclencher lorsque la tension instantanée entre les bornes 2a et 2b va atteindre la tension de claquage de l'une des diodes Zener 22a et 22b, selon le sens de la tension instantanée entre les deux bornes 2a et 2b; on rappelle que les diodes Zener sont passantes pour des tensions de sens contraire à celui de leur tension de claquage. La conduction de la chaîne optotriac 21, diodes Zener 22a et 22b, et la résistance 22c provoque l'injection de charges sur la gâchette du triac 20, commutateur principal, dont la conduction se déclenche. Ce déclenchement est retardé par rapport au passage à zéro de la tension entre les bornes 2a et 2b du temps nécessaire à la tension alternative du réseau pour atteindre la tension de claquage des diodes 22a et 22b.

Cela sera plus clair en se reportant à la figure 2, où la courbe 50 représente l'évolution de la tension entre les pôles P et N du réseau, la courbe 51 la tension entre les bornes 2a et 2b de l'interrupteur, et la courbe 52 la tension aux bornes de la charge 1. Il va de soi que la tension somme des courbes 51 et 52 est égale à la tension de la courbe 50.

On admettra que la charge 1 présente une impédance pratiquement dépourvue de composante réactive. Ainsi, lorsque la conduction du triac 20 n'est pas déclenchée, l'impédance entre les bornes 2a et 2b est très grande devant celle de la charge 1, et la tension instantanée entre ces bornes 2a et 2b est pratiquement égale à la tension de réseau, entre les pôles P et N, ce qui correspond au régime d'ouverture de l'interrupteur. Par contre, lorsque la conduction du triac 20 est déclenchée, la tension entre les bornes 2a et 2b est sensiblement nulle, et la tension sur la charge 1 est pratiquement la tension de réseau entre les pôles P et N, ce qui correspond globalement au régime de fermeture de l'interrupteur.

Sur la courbe 50, en soi sensiblement sinusoïdale, les droites en tireté, parallèles à l'axe des abscisses 54, 54', représentent les niveaux de tension de claquage des diodes 22a et 22b, respectivement. Pour la clarté de la figure, le rapport entre les tensions de claquage et l'amplitude de la tension de réseau a été exagéré. Dans la pratique, ces tensions de claquage sont de l'ordre de 30 volts, alors que l'amplitude de la tension de réseau (à 220 V) est d'environ 310 volts.

Les passages à zéro de la tension de réseau 50, sur une onde entière, sont les points 50a, 50c, 50e. Le passage au niveau 54 est le point 50b, et au niveau 54' le point 50d. Sur les courbes 51 et 52, les indices sont les mêmes pour des points synchrones.

Si l'on considère la tension 51 entre les bornes 2a, 2b de l'interrupteur, on voit qu'elle croît depuis zéro à partir du point 51 a, puis s'annule brusquement au point 51 b, en raison du déclenchement de la conduction du triac 20, pour rester nulle jusqu'au point 51c, puis décroître jusqu'au point 51d où elle atteint le niveau 54', et s'annule jusqu'au point 51e.

La tension 52 est le complément de la tension 51 pour la tension de réseau 50, entre les bornes 2a, 2b, c'est-à-dire nulle du point 52a au point 52b, où elle passe brusquement au niveau 54 pour reproduire la suite de la demi-onde jusqu'au point 52c où elle s'annule; elle reste alors nulle jusqu'au point 52d où elle passe au niveau 54' pour reproduire la suite de la seconde demi-onde jusqu'au point 52e. Si l'on prend en considération le rapport indiqué ci-dessus entre le niveau de tension de déclenchement de la conduction du triac 20 et l'amplitude de tension de réseau, on constate que le retard de déclenchement est d'environ 0,73 ms, pour un réseau à 50Hz. La tension 51 entre les bornes 2a et 2b est assimilable à une suite d'impulsions triangulaires de sens alterné et de durée courte, tandis que la tension 52 aux bornes de la charge 1 ne diffère pratiquement pas d'une tension sinusoïdale.

Mais, lorsque la borne d'entrée du signal de commande 49 est au même potentiel que la borne négative 47 de l'alimentation 4 (état inactif du signal de commande), la tension entre les bornes 2a et 2b est en permanence la tension du réseau.

En conséquence, le redresseur 3, en tête de l'alimentation 4 va recevoir, à travers le condensateur 30, soit une tension alternative pleine onde 50, soit une suite d'impulsions triangulaires de sens alterné à tension crête réduite et de durée courte devant la période du secteur 51, selon que l'interrupteur est respectivement ouvert et fermé.

La valeur du condensateur 30 doit être telle que:
En régime d'ouverture, la tension entre les entrées du pont redresseur 31 soit limitée pour éviter une surcharge de l'alimentation, notamment limiter le courant dans la diode Zener 40;
En régime de fermeture, l'énergie injectée dans le pont 31 et l'alimentation 4, à travers le condensateur 30, par la suite d'impulsions triangulaires 51, soit suffisante pour maintenir la charge de la capacité 44 malgré la consommation du pilote.

En pratique, on est conduit à donner au condensateur 30, pour alimenter convenablement le pilote en régime de fermeture, une valeur qui entraîne des pertes notables en régime d'ouverture; ces pertes nécessitent de surdimensionner les composants qui supportent ces pertes, tandis que la puissance délivrée au pilote en régime de fermeture est limitée, ce qui limite les fonctions de ce pilote. Par ailleurs, on pourrait penser augmenter la puissance disponible en régime de fermeture en augmentant le retard au déclenchement de la conduction du commutateur principal, par un accroissement de la tension de claquage des diodes Zener 22a, 22b. Mais de ce côté, on est limité également, car la tension nominale délivrée par l'alimentation 4 doit être compatible avec les tensions nominales d'emploi des composants utilisés dans le pilote; or la pointe de tension triangulaire (courbe 51) est certes supérieure à la tension nominale de l'alimentation, mais doit être du même ordre de grandeur pour que l'augmentation de tension à l'entrée de l'alimentation n'ait pas pour seul effet d'augmenter les pertes.

Selon le mode de réalisation de l'invention choisi et représenté figure 3, un triac 130 est monté en parallèle sur le condensateur 30, avec sa gâchette reliée à l'optotriac 21, ce triac 130 constituant commutateur auxiliaire.

Par ailleurs, l'alimentation 4 comporte, outre le transistor 41, qui reçoit sur sa base le signal de commande appliqué à la borne 49, un second transistor 140d, dont l'émetteur est relié à la sortie négative du pont 31, et dont le collecteur est relié à la sortie positive de ce pont à travers deux diodes Zener en série dans le même sens, 140a reliée à la sortie positive du pont 31, et 140b reliée au collecteur du transistor 140d. Du raccordement des diodes 140a et 140b part une troisième diode Zener 140c, de même sens que 140a. Cette diode Zener 140c aboutit à la base d'une résistance 140g reliée en tête à la sortie positive du pont 31. De la jonction de la diode Zener 140c et de la résistance 140g partent deux diodes 140e et 140f, en sens passant respectivement vers la base du transistor 140d et le collecteur du transistor 41.

Le fonctionnement est le suivant:

Lorsque le signal de commande est en état inactif, le triac ne conduit pas, et le redresseur 3 reçoit l'onde entière du réseau à travers la charge 1 et le condensateur 30, celui-ci étant dimensionné seulement pour que le redresseur 31 maintienne la charge de la capacité 44.

Dans l'alimentation 4, le transistor 41 est bloqué. Par ailleurs le transistor 140d a sa base reliée, à travers la diode 140e et la résistance 140g, à la sortie positive du pont redresseur 31, et est à l'état passant. Les diodes Zener en série 140a et 140b, à tension de claquage 12 volts environ chacune, se substituent alors à la diode Zener 40 de la figure 1, à tension de claquage 24 volts.

Si maintenant, un signal de commande actif apparaît sur la borne 49, le transistor 41 devient passant, et la diode électroluminescente 42 s'illumine. La conduction de l'optotriac 21 se déclenche au passage à zéro suivant de la tension entre les bornes 2a et 2b, cet optotriac 21 étant relié d'un côté à la borne 2b directement, et de l'autre côté, à travers une résistance de pied et le pont redresseur 31 à la borne 2a. Le triac 130 voit sa conduction déclenchée, et court-circuite le condensateur 30, appliquant ainsi intégralement la tension entre les bornes 2a et 2b aux entrées du pont redresseur 31.

Parallèlement, l'état passant du transistor 41 dépolarise le transistor 140d qui se bloque. La tension en sortie du pont redresseur 31 se trouve alors limitée par la série de diodes Zener 140a (12 V) et 140c (20 V), à 32 volts environ.

Comme la tension de claquage des diodes Zener 22a et 22b est de 30 volts, soit un peu moins que la somme des tensions de claquage des diodes Zener 140a et 140c, la conduction du triac 20, commutateur principal, intervient juste avant que les diodes Zener 140a et 140c limitent la tension sur le pont redresseur 31. Le fonctionnement du triac 20 est inchangé par rapport au montage de l'état de la technique, représenté figure 1. La conduction du triac 20 annule la tension entre les bornes d'interrupteur 2a et 2b. La tension sur le triac 130, commutateur auxiliaire, s'annule également, et sa conduction cesse.

Le même processus se déroule à chaque demi-onde.

On comprend qu'ainsi, on peut déterminer la valeur du condensateur 30 en fonction uniquement du maintien de la tension fournie par l'alimentation 4, entre les bornes de sortie 47 et 48, lorsque l'interrupteur est en régime d'ouverture avec le signal de commande sur la borne 49 inactif. La puissance que peut absorber le pilote quand l'interrupteur est en régime de fermeture devient essentiellement fonction du retard au déclenchement de la conduction du triac 20, et de la valeur de la capacité de filtrage 44.

Bien que la description n'ait fait état que de triacs (20 et 130) pour remplir les rôles de commutateurs principal et auxiliaire, notamment parce que la gâchette peut commander le déclenchement de la conduction dans les deux sens, il va de soi que tout montage de semi-conducteurs à conduction déclenchée permettant une conduction bidirectionnelle, tel que le montage de thyristors tête-bêche, peut être utilisé pour la mise en oeuvre de l'invention.

Aussi, bien entendu, l'invention n'est pas limitée aux exemples décrits, mais en embrasse toutes les variantes d'exécution, dans le cadre des revendications.

## Revendications

1. Interrupteur à monter en série avec une charge (1) entre deux pôles (N,P) d'un réseau de distribution électrique alternative, présentant deux bornes (2a,2b) à relier respectivement à un pôle (P) du réseau et à la charge (1), celle-ci étant reliée par ailleurs à l'autre pôle (N) du réseau, et comportant un commutateur principal (20) à conduction bidirectionnelle déclenchée branché entre les deux bornes (2a,2b), et un pilote (3,4) apte, en réponse à un état actif d'un signal de commande, à déclencher la conduction du commutateur principal (20) avec un retard déterminé sur le passage à zéro de la tension entre les deux bornes (2a,2b), le pilote comportant une alimentation (3,4) à redresseur (31) branchée par une première entrée directement à une première des deux bornes (2a) et, par une seconde entrée à la seconde borne (2b) à travers un condensateur (30) propre à limiter le courant dans l'alimentation (3,4), **caractérisé en ce que** le pilote (3,4) comprend un commutateur auxiliaire (130) à conduction bidirectionnelle déclenchée monté en parallèle sur le condensateur (30), la conduction du commutateur auxiliaire (130) étant déclenchée à chaque passage à zéro de la tension entre les deux bornes (2a,2b), avec le signal de commande à l'état actif.

2. Interrupteur selon la revendication 1, **caractérisé en ce que** les commutateurs, principal (20) et auxiliaire (130), sont des triacs avec une gâchette déclenchant la conduction dans les deux sens.

3. Interrupteur selon l'une des revendications 1 et 2, **caractérisé en ce que** la conduction du commutateur principal (20) est déclenchée par le passage à un niveau réglé d'une tension dérivée de la tension entre les entrées de l'alimentation (3,4).

4. Interrupteur selon la revendication 3, **caractérisé en ce que** la gâchette du commutateur principal (20) reçoit la tension dérivée de la tension à l'entrée de l'alimentation (3,4) à travers deux diodes Zener (22a,22b) en série, de sens opposés.

5. Interrupteur selon l'une des revendications 3 et 4, **caractérisé en ce que** l'alimentation (3,4) comprend un pont redresseur (31) chargeant une capacité de filtrage (44) à travers une diode anti-retour (43), et un transistor (140d) couplé à au moins une diode Zener (140a,140b) formant limiteur de tension redressée.

6. Interrupteur selon la revendication 5, **caractérisé en ce que** le pilote (3,4) comporte en outre un transistor (41) rendu passant par l'état actif du signal de commande, et monté en série avec une diode électroluminescente (42) branchée en sortie du redresseur (31) en amont de la diode anti-retour (43) et optiquement couplée à un phototriac (21), celui-ci étant monté pour déclencher, à l'état passant, la conduction du commutateur auxiliaire (130).

## Claims

1. A switch to be connected in series with a load (1) between two poles (N, P) of an alternating electrical distribution network, having two terminals (2a, 2b) to be respectively connected to a pole (P) of the network and to the load (1), the latter also being connected to the other pole (N) of the network, and comprising a main switch (20) with triggered bi-directional conduction which is connected between the two terminals (2a, 2b), and a pilot means (3, 4) which in response to an active state of a control signal is capable of triggering conduction of the main change-over switch (20) with a given delay in relation to the zero-passage of the voltage across the two terminals (2a, 2b), the pilot means comprising a power supply (3, 4) with a rectifier (31) which is connected by way of a first input directly to a first of the two terminals (2a) and by way of a second input to the second terminal (2b) through a capacitor (30) for limiting the current in the power supply (3, 4), **characterised in that** the pilot means (3, 4) comprises an auxiliary change-over switch (130) with triggered bi-directional conduction which is connected in parallel with the capacitor (30), conduction of the auxiliary change-over switch (130) being triggered at each zero-passage of the voltage across the two terminals (2a, 2b) with the active state control signal.

2. A switch according to claim 1 **characterised in that** the main switch (20) and the auxiliary switch (130) are triacs with a gate triggering conduction in both directions.

3. A switch according to one of claims 1 and 2 **characterised in that** conduction of the main switch (20) is triggered by the passage to a regulated level of a voltage derived from the voltage across the inputs of the power supply (3, 4).

4. A switch according to claim 3 **characterised in that** the gate of the main change-over switch (20) receives the voltage derived from the voltage at the input of the power supply (3, 4) by way of two Zener diodes (22a, 22b) in series in opposite directions.

5. A switch according to one of claims 3 and 4 **characterised in that** the power supply (3, 4) comprises a rectifier bridge (31) charging a filtering capacitor (44) by way of a non-return diode (43) and a transistor (140d) coupled to at least one Zener diode (140a, 140b) forming a rectified voltage limiter.

6. A switch according to claim 5 **characterised in that** the pilot means (3, 4) further comprises a transistor (41) which is caused to conduct by the active state of the control signal and connected in series with a light emitting diode (42) connected at the output of the rectifier (31) upstream of the non-return diode (43) and optically coupled to a phototriac (21), the latter being connected to trigger in the conducting state the conduction of the auxiliary change-over switch (130).

## Patentansprüche

1. Schaltgerät, das in Reihe mit einer Last (1) zwischen zwei Polen (N, P) eines elektrischen Wechselstromverteilungsnetzes installierbar ist und zwei Klemmen (2a, 2b) jeweils zur Verbindung mit einem Pol (P) des Netzes und mit der Last (1) aufweist, wobei letztere außerdem mit dem anderen Pol (N) des Netzes verbunden ist, und das einen Hauptschalter (20) zur getriggerten bidirektionalen Leitung, der zwischen die beiden Klemmen (2a, 2b) geschaltet ist, und einen Treiber (3, 4) umfasst, der dafür geeignet ist, in Ansprechen auf einen aktiven Zustand eines Steuersignals das Leiten des Hauptschalters (20) mit einer bestimmten Verzögerung beim Nulldurchgang der Spannung zwischen den beiden Klemmen (2a, 2b) zu triggern, wobei der Treiber eine Versorgung (3, 4) mit einem Gleichrichter (31) umfasst, die mit einem ersten Eingang direkt mit einer ersten der beiden Klemmen (2a) und mit einem zweiten Eingang mit einer zweiten Klemme (2b) über einen Kondensator (30) geschaltet ist, der dafür geeignet ist, den Strom in der Versorgung (3, 4) zu begrenzen, **dadurch gekennzeichnet, dass** der Treiber (3, 4) einen Zusatzschalter (130) zur getriggerten bidirektionalen Leitung umfasst, der parallel zu dem Kondensator (30) installiert ist, wobei das Leiten des Zusatzschalters (130) bei jedem Nulldurchgang der Spannung zwischen den beiden Klemmen (2a, 2b) bei aktivem Zustand des Steuersignals getriggert wird.

2. Schaltgerät nach Anspruch 1,
**dadurch gekennzeichnet, dass** der Hauptschalter (20) und der Zusatzschalter (130) Triacs mit einem Gate sind, das das Leiten in den beiden Richtungen triggert.

3. Schaltgerät nach einem der Ansprüche 1 oder 2,
**dadurch gekennzeichnet,**
**dass** das Leiten des Hauptschalters (20) getriggert wird, wenn eine Spannung, die von der Spannung zwischen den Eingängen der Versorgung (3, 4) abgeleitet wird, einen geregelten Pegel passiert.

4. Schaltgerät nach Anspruch 3,
**dadurch gekennzeichnet,**
**dass** das Gate des Hauptschalters (20) die Spannung, die von der Spannung am Eingang der Versorgung (3, 4) abgeleitet wird, über zwei Zener-Dioden (22a, 22b) empfängt, die gegensinnig in Reihe geschaltet sind.

5. Schaltgerät nach einem der Ansprüche 3 oder 4,
**dadurch gekennzeichnet,**
**dass** die Versorgung (3, 4) eine Gleichrichterbrücke (31), die einen Filterkondensator (44) über eine Anti-Rückfluß-Diode (43) lädt, und einen Transistor (140d) umfasst, der mit mindestens einer ZenerDiode (140a, 140b) gekoppelt ist, die einen Begrenzer für die gleichgerichtete Spannung bildet.

6. Schaltgerät nach Anspruch 5,
**dadurch gekennzeichnet,**
**dass** der Treiber (3, 4) ferner einen Transistor (41) umfasst, der durch einen aktiven Zustand des Steuersignals durchlässig wird und mit einer Leuchtdiode (42) in Reihe geschaltet ist, die am Ausgang des Gleichrichters (31) stromaufwärts von der Anti-Rückfluß-Diode (43) abgezweigt ist und optisch mit einem Photo-Triac (21) gekoppelt ist, wobei letzterer installiert ist, um im durchlässigen Zustand das Leiten des zusätzlichen Schalters (130) zu triggern.
